# EUROPEAN PATENT SPECIFICATION

(11) **EP 4 418 328 B1**
(45) Date of publication and mention of the grant of the patent: **29.04.2026**
(21) Application number: 24157994.5
(22) Date of filing: 16.02.2024
(51) Int. Cl.: H10D 30/01, H10D 30/62, H10D 30/63, H10D 64/01

(54) **TRANSISTOR STRUCTURE WITH MULTIPLE VERTICAL THIN BODIES**
TRANSISTORSTRUKTUR MIT MEHREREN VERTIKALEN DÜNNEN KÖRPERN
STRUCTURE DE TRANSISTOR À CORPS MINCES VERTICAUX MULTIPLES

(30) Priority: 17.02.2023 US 202363446361 P
(43) Date of publication of application: 21.08.2024
(73) Proprietor: Invention and Collaboration Laboratory, Inc., Taipei City 114 (TW)
(72) Inventor: LU, Chao-Chun, 106 Taipei City (TW)
(74) Representative: Straus, Alexander

(56) References cited:
- EP-A1- 4 125 134
- EP-A2- 3 968 375
- US-A1- 2019 140 066

## Description

### Field of the Invention

The present invention relates to a transistor structure according to claim 1.

### Background of the Invention

Monolithic integration of silicon integrated circuits (IC) has achieved realization of more than 50 billions of transistors on a die in the year of 2021, which has been named as an era of GSI (Gigabit-Scale Integration, i.e. Achieving more than billions of transistors on a die) from VLSI (Very Large Scale Integration having more than millions of transistors on a die). Such accomplishments of making much higher integration capacity of transistors on a die have sharply enabled more powerful microsystems with significantly improved PPAC (Performance, Power, Area, and Cost), thus creating many powerful chips such as central processing unit (CPU), graphics processing unit (GPU), field programmable gate array (FPGA), system on a chip (SOC), static random-access memory (SRAM), dynamic random access memory (DRAM), etc., which enhances system capabilities so as to continually support Moore's Law which formed a base to create an exponential Economic growth.

With such a high productivity generated from GSI to grow new applications which stimulates fast growth of economic scale, there are very strong demands to integrate more transistors on a die. So it is expected that semiconductor industry tries every best efforts to march toward a TSI (Tera-Scale Integration), that is, integration of more than trillions of transistors on a die for a chip. Therefore, how to sharply improve the transistor to meet this TSI challenge requires Inventions and engineering improvements of some fundamentally changed transistor structure with better PPAC. For example, if a chip does integrate one trillion transistors on a die, if each transistor is set at achieving a standby current (or called loff) about 0.5 pA (abbreviation of Ampere), then a total of one trillion of transistors will have its loff of a die is approaching 0.5 Amperes.

The state-of-art transistor with less than 20nm technologies can hardly achieved this loff of 0.5 pA, however; even by using various transistor structures such as FinFET or Tri-gate designs, some loff's can be as large as 5 to 10 pA. How to continuously shrink the device dimensions plus to reduce loff (such as lower than 1pA) is the key challenge.

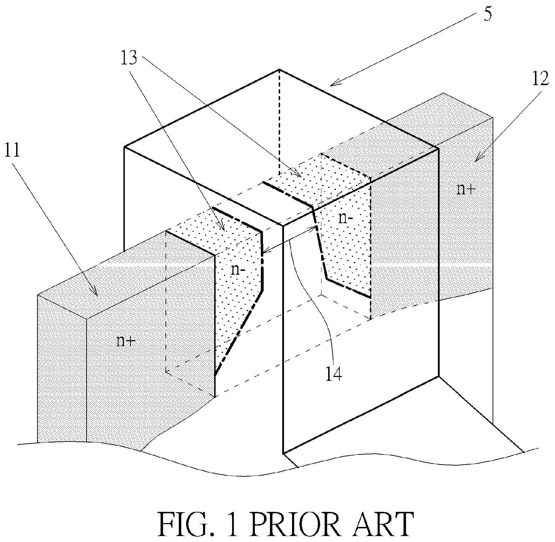

An example of state-of-the-art Field-Effect Transistor (FinFET) with active region which is formed as a fin structure is shown in FIG. 1. A gate structure 5 of the transistor using some conductive material (like metal, polysilicon or polyside, etc.) over an insulator or dielectric layer (such as oxide, oxide/nitride or some high-k dielectric, etc.) is formed on a fin structure or a three-dimensional convex silicon surface. Using an NMOS transistor as example, there are source region 11 and drain region 12 which are formed by an ion-implantation plus thermal annealing technique to implant high concentration n-type dopants into a p-type substrate (or a p-well) which thus results in two separated n+/p junction areas. Furthermore, to lessen impact ionization and hot carrier injection prior to highly doped n+/p junction, it is common to form a lightly doped drain (LDD) region 13 before the highly doped n+ source/drain region by ion-implantation plus thermal annealing technique, and such ion-implantation plus thermal annealing technique frequently causes the LDD regions 13 penetrating underneath the gate structure, as shown in FIG.1. Therefore, a length of an effective channel 14 between the LDD regions 13 is unavoidably shortened.

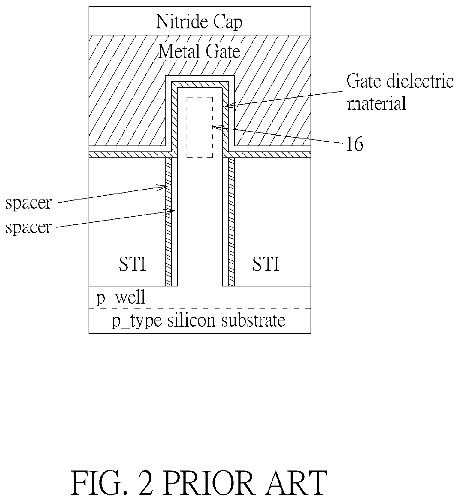

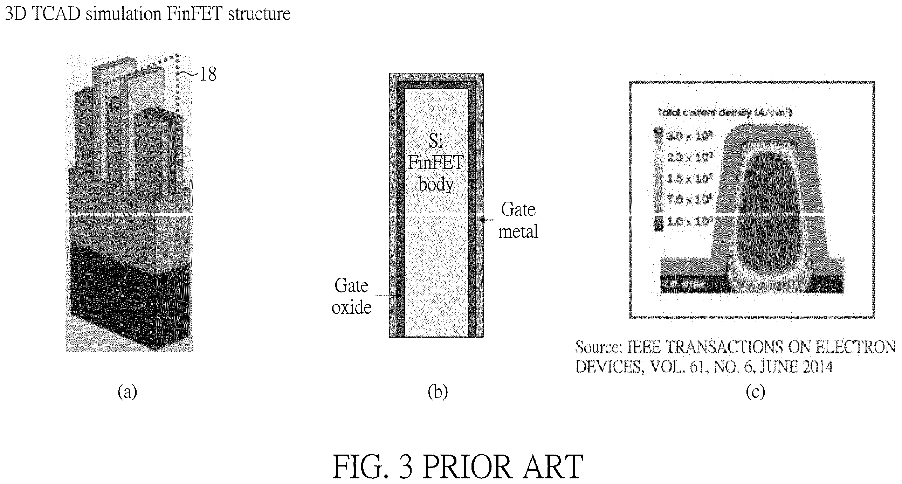

On the other hand, the advancement of manufacturing process technologies is continuing to move forward rapidly by scaling down the geometries of devices in both horizontal and vertical dimensions (such as the minimum feature size called as Lamda (λ) is shrunk from 28nm down to 5nm or 3nm). But many problems are introduced or getting worse due to such FinFET or Tri-gate geometry scaling:
(1) As the device gate length is scaled down, its OFF state current (Ioff) is getting harder to be reduced. A higher leakage current path (the dash rectangle region 16 in FIG. 2 which is a cross section) is formed within fin structure, rather than only along the surface of the fin structure. Such leakage current path was evaluated and simulated as shown in FIG. 3. FIG. 3(a) is a 3D FinFET structure under Technology Computer-Aided Design (TCAD) simulation, FIG. 3(b) is a cross section view of the 3D FinFET structure corresponding to a red dot rectangle 18 in FIG. 3(a), and FIG. 3(c) is an OFF state current distribution (see, "Impact of Current Flow Shape in Tapered (Versus Rectangular) FinFET on Threshold Voltage Variation Induced by Work-Function Variation", IEEE TRANSACTIONS ON ELECTRON DEVICES, VOL. 61, NO. 6, JUNE 2014).
(2) As the device dimensions are scaled down, it's getting harder to align the LDD junction edge (or source/drain edge) to the edge of gate structure in a perfect position by only following the conventional self-alignment method of using gate, spacer and ion-implantation formation. In addition, the Thermal Annealing process for removing the ion-implantation damages must count on high temperature processing techniques such as Rapid Thermal Annealing method by using various energy sources or other thermal processes. One problem thus created is that a gate-Induced drain Leakage (GIDL) leakage current is hard to be controlled regardless the fact that it should be minimized in order to reduce leakage currents; the other problem as created is that the effective channel length is difficult to be controlled and so the short channel effect (SCE) is hardly minimized. It is difficult to adjust the relative position between the source/drain edge to the edge of gate structure such that the GIDL could be better controlled.
(3) Since the ion-implantation to form the LDD structure (or the n+/p junction in NMOS or the p+/n junction in PMOS) works like bombardments in order to insert ions from the top of a silicon surface straight down to the substrate, it is hard to create uniform material interfaces with lower defects from the source and drain regions to the channel and the substrate-body regions since the dopant concentrations are non-uniformly distributed vertically from the top surface with higher doping concentrations down to the junction regions with lower doping concentrations.
(4) As the device dimension is scaled down to 7nm, 5nm or 3nm, a height of the fin structure (such as 40~100nm) of the NMOS transistor is far larger than a width of the fin structure (such as 3~10nm) of the NMOS transistor such that the fin structure is vulnerable or even collapsed during the subsequent processes (such as source/drain formation, gate formation, etc.).

Therefore, the present invention discloses a new 3D transistor structure to solve the above-mentioned disadvantages of the conventional transistor, for example, the new 3D transistor structure can reduce loff current by 10 to 100 times.

Several prior arts related transistor structure have been proposed, e.g. US20190140066A1 and EP4125134A1. US20190140066A1 provides an integrated circuit device and a method of manufacturing the same. The integrated circuit device includes: a semiconductor substrate; a device isolation layer defining an active region of the semiconductor substrate; a gate insulating layer on the active region; a gate stack on the gate insulating layer; a spacer on a sidewall of the gate stack; and an impurity region provided on both sides of the gate stack, wherein the gate stack includes a metal carbide layer and a metal layer on the metal carbide layer, wherein the metal carbide layer includes a layer having a carbon content of about 0.01 at % to about 15 at %.

EP4125134A1 discloses a transistor structure. The transistor structure includes a substrate, a gate conductive region, a gate dielectric layer, and a sheet channel layer. The substrate has a body region. The gate conductive region is above the body region. The gate dielectric layer is between the gate conductive region and the body region. The sheet channel layer is disposed between the body region and the gate dielectric layer, wherein the sheet channel layer is independent from the substrate. A doping concentration of the body region is higher than a doping concentration of the sheet channel layer.

### Summary of the Invention

The present invention aims at providing a transistor structure that has multiple vertical thin semiconductor bodies (or "VTB"), wherein the transistor structure with VTB can not only effectively reduce the leakage current path during the OFF state of the transistor structure on one hand, but also dramatically enhance the conduction current during the ON state of the transistor structure.

This is achieved by a transistor structure according to claim 1. The dependent claims pertain to corresponding further developments and improvements.

As will be seen more clearly from the detailed description following below, the claimed transistor structure. The transistor structure includes a body and a gate structure. The body has a single convex structure, wherein the convex structure is made of a first semiconductor material, and a trench is formed in the single convex structure. The gate structure has a gate conductive layer and a gate dielectric layer, wherein the gate conductive layer is across over the single convex structure, and a first portion of the gate conductive layer is filled in the trench. The single convex structure comprises two vertical thin bodies, and the gate dielectric layer is disposed between the gate conductive layer and the two vertical thin bodies

According to one aspect of the present invention, the transistor structure further includes a source region, a drain region, a first concave, and a second concave. The source region contacts with a first end of the single convex structure. The drain region contacts with a second end of the single convex structure. The first concave accommodates the source region. The second concave accommodates the drain region. Sidewalls of the first concave and sidewalls of the second concave are surrounded by a STI region.

According to one aspect of the present invention, an edge of the source region contacts with the two vertical thin bodies, and an edge of the drain region contacts with the two vertical thin bodies.

According to one aspect of the present invention, the source region includes an LDD region, a heavily doped region, and a metal region. The LDD region contacts with the two vertical thin bodies. The heavily doped region laterally extends from the LDD region. The metal region is in the first concave and contacts with a sidewall of the heavily doped region.

According to one aspect of the present invention, the transistor structure further includes an oxide layer and a nitride layer. The oxide layer is positioned in the first concave, the oxide layer includes a vertical portion and a lateral portion covering a bottom of the first concave; wherein a top surface of the vertical portion is higher than that of the lateral portion. The nitride layer is above the oxide layer.

According to one aspect of the present invention, a width of one vertical thin body is not greater than 3nm.

According to one aspect of the present invention, the convex structure has a first end, a second end, and multiple conductive channels. The first portion of the gate conductive layer filled in the convex structure is under the original surface, and a second portion of the gate conductive layer is above the original surface, wherein a length of the second portion of the gate conductive layer is longer than that of the first portion of the gate conductive layer.

According to one aspect of the present invention, the trench formed in the convex structure is between the first end and the second end of the single convex structure, the single convex structure comprises two thin bodies extending upward, each thin body comprises two conductive channels along sidewalls of the thin body, and the trench filled with the first portion of the gate conductive layer is between the two thin bodies .

According to one aspect of the present invention, the gate dielectric layer is across over the convex structure, the first portion of the gate conductive layer is surrounded by the gate dielectric layer in the trench, and right under the bottom of the trench is the semiconductor material of the body, and the gate dielectric layer along the bottom of the trench directly contacts with the semiconductor material of the bod.

According to one aspect of the present invention, the single convex structure has a trench formed therein and includes at least 4 upward extended conductor-oxide-semiconductor interfaces on the two vertical thin bodies.

The at least 4 upward extended conductor-oxide-semiconductor interfaces are horizontally shifted with each other.

According to one aspect of the present invention, the single convex structure includes two upward extending thin bodies, and each upward extending thin body includes two upward extending conductor-oxide-semiconductor interfaces.

According to one aspect of the present invention, no STI region is between the two upward extending bodies, and the convex structure is made of a first semiconductor material, a bottom of the trench directly contacts with the first semiconductor material.

According to one aspect of the present invention, a trench is formed in the single convex structure to separate the two upward extending thin bodies.

According to one aspect of the present invention, the transistor structure further includes a single source region and a single drain region, wherein the single source region is selectively grown from a first end of the single convex structure, and the single drain region is selectively grown from a second end of the single convex structure.

### Brief Description of the Drawings

The present invention is further illustrated by way of example, taking reference to the accompanying drawings thereof:
FIG. 1 is a diagram illustrating a FinFET according to the prior art,
FIG. 2 is a diagram illustrating a higher leakage current path formed within fin structure,
FIG. 3 is a diagram illustrating a 3D FinFET structure under Technology Computer-Aided Design (TCAD) simulation, a cross section view of the 3D FinFET structure, and an OFF state current distribution,
FIG. 4A is a flowchart illustrating a manufacturing method of a vertical thin body field-effect transistor (VTBFET) according to one embodiment of the present invention,
FIG. 4B, FIG. 4C, FIG. 4D, FIG. 4E are diagrams illustrating FIG. 4A,
FIG. 5 is a diagram illustrating the pad-oxide layer being grown, the pad-nitride layer being deposited, and the trench being formed,
FIG. 6 is a diagram illustrating the oxide spacer being deposited on the p-type well and the nitride spacer being deposited on the oxide spacer,
FIG. 7 is a diagram illustrating the shallow trench isolation (STI) being formed and the thin nitride layer being deposited,
FIG. 8 is a diagram illustrating the gate region across over the active region and the isolation region being defined,
FIG. 9 is a diagram illustrating the photolithographic (PR) mask being removed,
FIG. 10 is a diagram illustrating the nitride spacer-2 being formed and based on the nitride spacer-2 to form the trench,
FIG. 11 is a diagram illustrating the thermal oxide being grown to fill the trench to form the central pole and then the nitride cap over the central pole being formed,
FIG. 12 is a diagram illustrating the exposed STI being etched back to create the fin-shape,
FIG. 13 is a diagram illustrating the nitride cap and the nitride spacer-2 in the central pole related area being removed,
FIG. 14 is a diagram illustrating the pad-oxide layer in the central pole related area and the oxide spacer covering the fin-shape being removed, and the STI corresponding to the gate region being also etched down,
FIG. 15 is a diagram illustrating the central pole being removed and a trench-2 being revealed,
FIG. 16 is a diagram illustrating the gate dielectric being formed and the gate material being deposited in the gate region,
FIG. 17 is a diagram illustrating the cap layer being deposited and then the STI being etched,
FIG. 18 is a diagram illustrating the pad-nitride layer and the pad-oxide layer being etched away, some portion of the STI being etched back, and the oxide-2 spacer and the nitride-2 spacer being formed on the edges of the gate structure,
FIG. 19 is a diagram illustrating some exposed silicon areas being etched away to create shallow trenches for the source and the drain, using the thermal oxidation process to grow the oxide-3 layer, and using CVD to deposit nitride and etch back nitride,
FIG. 20 is a diagram illustrating the tungsten layer being deposited and then the TiN layer being deposited above the tungsten layer,
FIG. 21 is a diagram illustrating the portion of the oxide-3V layer being etched away to reveal silicon sidewalls, then the n-type LDDs, the n+ doped source, and n+ doped drain being formed, and then the TiN layer the Tungsten layer being deposited,
FIG. 22 is a diagram illustrating the landing pads being formed over the n+ doped source and n+ doped drain,
FIG. 23 is a diagram illustrating the TCAD simulation results of the Ion regarding the conventional FinFET and the VTBFET of the present invention,
FIG. 24 is a diagram illustrating the TCAD simulation results of the loff regarding the conventional FinFET and the VTBFET of the present invention, and
FIG. 25 shows structure differences between the conventional FinFET and the VTBFETs of the present invention.

### Detailed Description

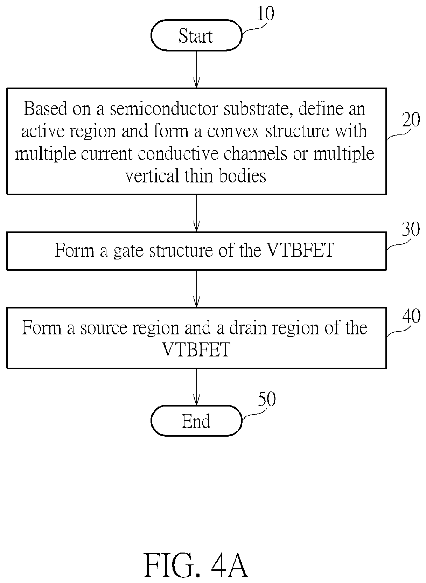

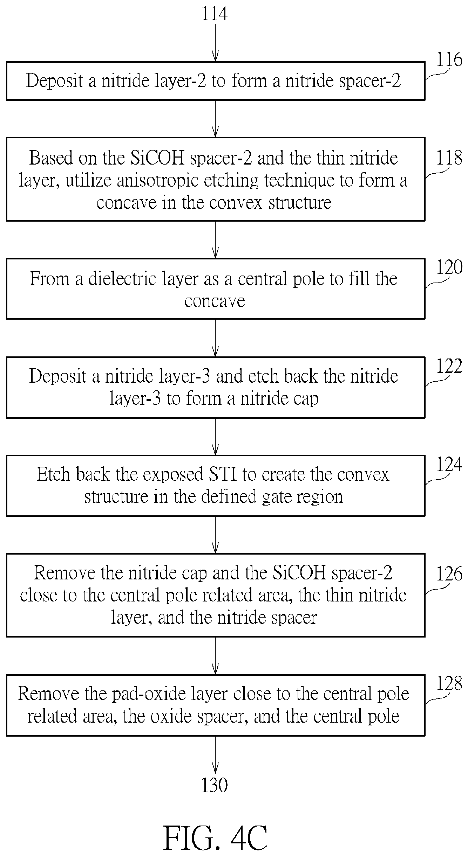

Please refer to FIGS. 4A, 4B, 4C, 4D, 4E, 5, 6, 7, 8, 9, 10, 11, 12, 13, 14, 15, 16, 17, 18, 19, 20, 21, 22, wherein FIG. 4A is a flowchart illustrating a manufacturing method of a vertical thin body field-effect transistor (VTBFET) according to one embodiment of the present invention, and the manufacturing method of the VTBFET in FIG. 4A can make the VTBFET have lower standby current, lower gate-induced drain leakage (GIDL) current and lower short channel effect (SCE), and form a solid fence wall to clamp an active region or a narrow convex structure of the VTBFET. Detailed steps of the manufacturing method of the VTBFET (using N type as an example) are as follows:

| | |
|---|---|
| Step 10: | Start. |
| Step 20: | Based on a semiconductor substrate 200, define an active region and form a convex structure with multiple current conductive channels or multiple vertical thin bodies. |
| Step 30: | Form a gate structure of the VTBFET. |
| Step 40: | Form a source region and a drain region of the VTBFET. |
| Step 50: | End. |

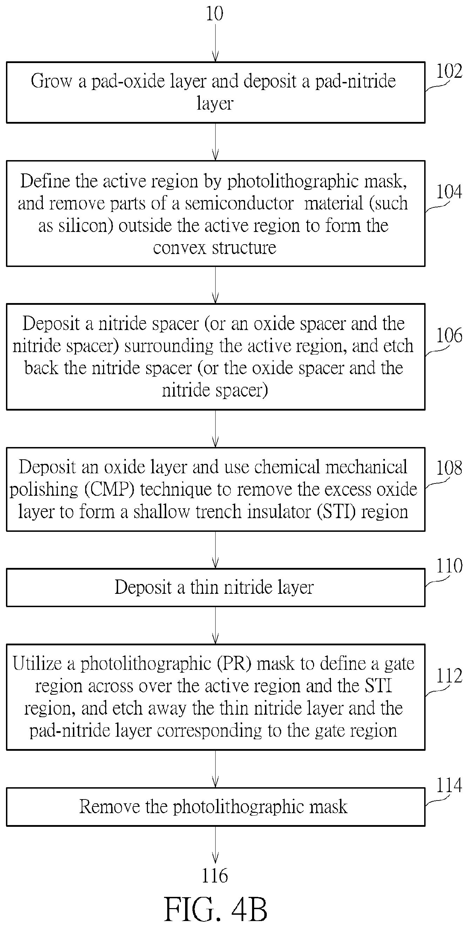

Please refer to FIGS. 4B, 4C and FIGS. 5, 6, 7, 8, 9, 10, 11, 12, 13, 14, 15. Step 20 could include:

| | |
|---|---|
| Step 102: | Grow a pad-oxide layer 204 and deposit a pad-nitride layer 206. |
| Step 104: | Define the active region by photolithographic mask, and remove parts of a semiconductor material (such as silicon) outside the active region to form the convex structure. |
| Step 106: | Deposit a nitride spacer 306 (or an oxide spacer 304 and the nitride spacer 306) surrounding the active region, and etch back the nitride spacer 306 (or the oxide spacer 304 and the nitride spacer 306). |
| Step 108: | Deposit an oxide layer and use chemical mechanical polishing (CMP) technique to remove the excess oxide layer to form a shallow trench insulator (STI) region 402. |
| Step 110: | Deposit a thin nitride layer 802. |
| Step 112: | Utilize a photolithographic (PR) mask 902 to define a gate region across over the active region and the STI region 402, and etch away the thin nitride layer 802 and the pad-nitride layer 206 corresponding to the gate region. |
| Step 114: | Remove the photolithographic mask 902, wherein a central pole related area is defined within the active region. |
| Step 116: | Deposit a SiCOH layer (or a combination of oxide/nitride layer) to form a SiCOH spacer-2 1102. |
| Step 118: | Based on the SiCOH spacer-2 1102 and the thin nitride layer 802, utilize anisotropic etching technique to form a concave (or trench) |
| | 1202 in the convex structure. |
| Step 120: | From a dielectric layer (such as a thermal oxide) as a central pole 1302 to fill the concave 1202. |
| Step 122: | Deposit a nitride layer-3 and etch back the nitride layer-3 to form a nitride cap 1402. |
| Step 124: | Etch back the exposed STI 402 to create the convex structure in the defined gate region. |
| Step 126: | Remove the nitride cap 1402 and the SiCOH spacer-2 1102 close to the central pole related area, the thin nitride layer 802, and the nitride spacer 306. |
| Step 128: | Remove the pad-oxide layer 204 close to the central pole related area, the oxide spacer 304, and the central pole 1302. |

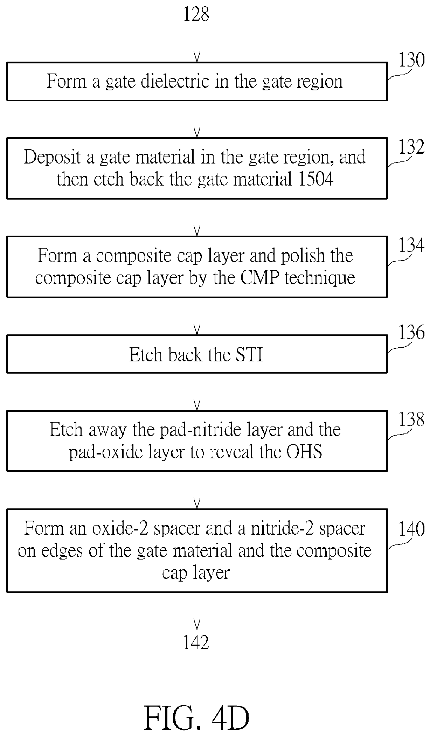

Please refer to FIG. 4D and FIGS. 16, 17, 18. Step 30 could include:

| | |
|---|---|
| Step 130: | Form a gate dielectric 1502 in the gate region. |
| Step 132: | Deposit a gate material 1504 in the gate region, and then etch back the gate material 1504. |
| Step 134: | Form a cap layer 1506 and polish the cap layer 1506 by the CMP technique. |
| Step 136: | Etch back the STI 402. |
| Step 138: | Etch away the pad-nitride layer 206 and the pad-oxide layer 204 to reveal the OHS. |
| Step 140: | Form an oxide-2 spacer 1802 and a nitride-2 spacer 1804 on edges of the gate material 1504 and the cap layer 1506. |

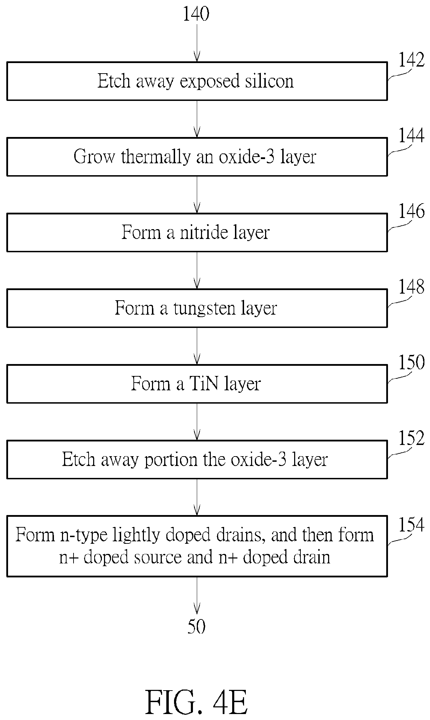

Please refer to FIG. 4E and FIGS. 19, 20, 21, 22. Step 40 could include:

| | |
|---|---|
| Step 142: | Etch away exposed silicon. |
| Step 144: | Grow thermally an oxide-3 layer 1002. |
| Step 146: | Form a nitride layer 1904. |
| Step 148: | Form a tungsten layer 1906. |
| Step 150: | Form a TiN layer 1908. |
| Step 152: | Etch away portion the oxide-3 layer 1002. |
| Step 154: | Form n-type lightly doped drains (LDDs) 2004, 2006, and then form n+ doped source 2008 and n+ doped drain 2010. |

Detailed description of the aforesaid manufacturing method is as follows. Using NMOS transistor for illustration purpose, start with the well-designed doped p-type well 202 installed in a p-type semiconductor substrate 200 (wherein in another embodiment of the present invention, could start with the p-type substrate 200, rather than starting with the p-type well 202), wherein in one example the p-type well 202 has its top surface counted down about 500nm thick from the OHS. In addition, for example, the p-type substrate 200 has concentration close to 1x10^16 dopants/cm^3. The actual dopant concentrations will be decided by final mass production optimizations.

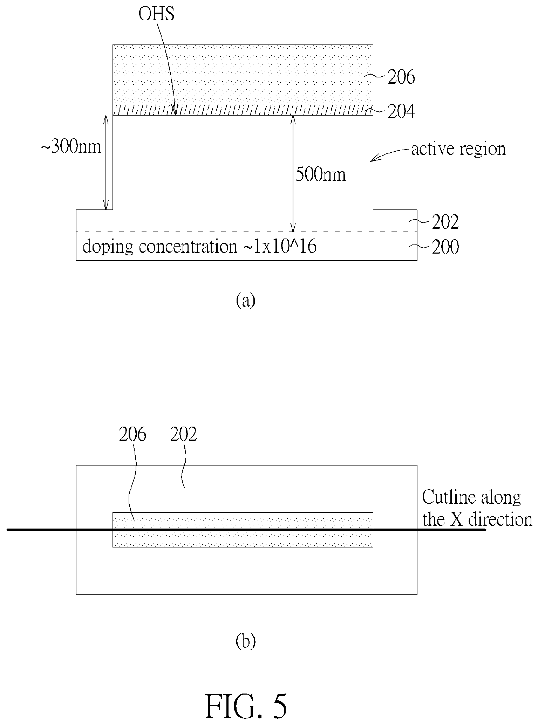

In Step 102, as shown in FIG. 5(a), grow the pad-oxide layer 204 with well-designed thickness over the OHS and deposit the pad-nitride layer 206 with well-designed thickness on a top surface of the pad-oxide layer 204.

In Step 104, as shown in FIG. 5(a), use a photolithographic masking technique to define the active region for the VTBFET by an anisotropic etching technique, wherein the anisotropic etching technique removes parts of a semiconductor material (such as silicon) outside the active regions to create the trench (e.g. about 300nm deep) for future STI (shallow trench isolation) needs, such that a convex structure of the active region is created as well. In addition, FIG. 5(b) is a top view corresponding to FIG. 5(a), wherein FIG. 5(a) is a cross-section view along a cutline of an X direction shown in FIG. 5(b).

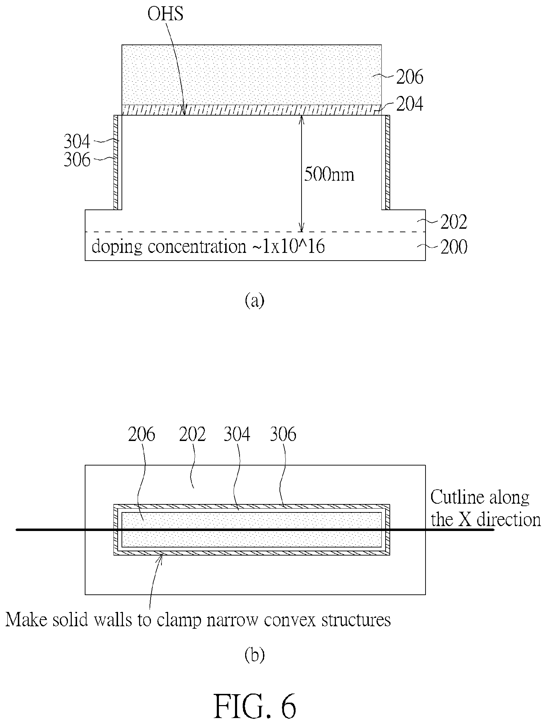

In Step 106, as shown in FIG. 6(a), deposit the oxide spacer 304 on the edge of the active region and then the nitride spacer 306 on the oxide spacer 304 (or just deposit the nitride spacer 306 on the edge of the active region), and use the anisotropic etching technique to etch back the oxide spacer 304 and the nitride spacer 306 to make top surfaces of the oxide spacer 304 and the nitride spacer 306 are in level up to the OHS, wherein the oxide spacer 304 and the nitride spacer 306 are outside the active region. Thus, the key point here is that the oxide spacer 304 and then the nitride spacer 306 (or just the nitride spacer 306) form a solid fence wall to clamp the active region or the narrow convex structure, especially the sidewalls of the convex structure. The solid clamping wall could be a single layer (such as the nitride spacer 306) or other composite layers (such as the oxide spacer 304 and the nitride spacer 306) to protect the narrow convex or fin structure from collapse during the forming the source/the drain or the gate of the VTBFET.

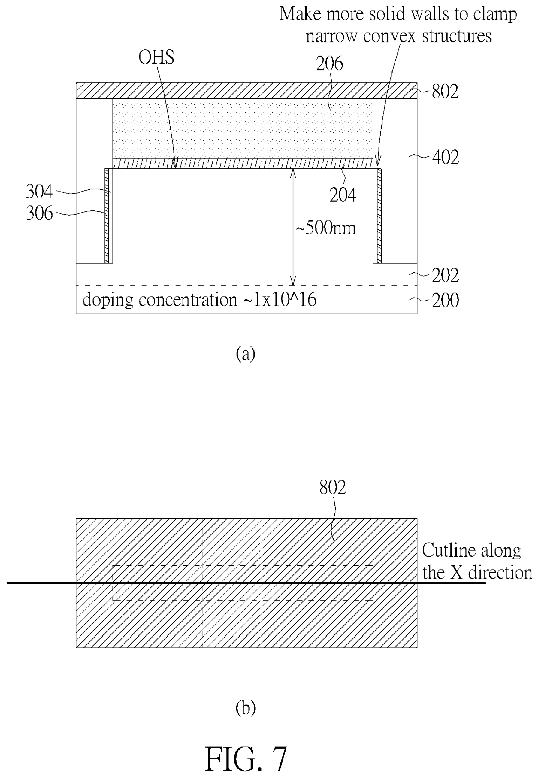

In Step 108, as shown in FIG. 7(a), deposit the thick oxide layer to fully fill the trench surrounding the active region and use the CMP technique to remove the excess oxide layer to form the STI region 402, wherein a top surface of the STI region 402 is in level up to a top surface of the pad-nitride layer 206. Again, the STI region 402 further encompass or clamp the active region or the narrow convex structure, especially the sidewalls of the convex structure, to protect the narrow convex structure from collapse during the forming the source/the drain or the gate of the VTBFET.

In Step 110, as shown in FIG. 7(a), deposit the thin nitride layer 802 over the pad-nitride layer 206 and the STI region 402. In addition, FIG. 7(b) is a top view corresponding to FIG. 7(a), wherein FIG. 7(a) is a cross-section view along a cutline of an X direction shown in FIG. 7(b).

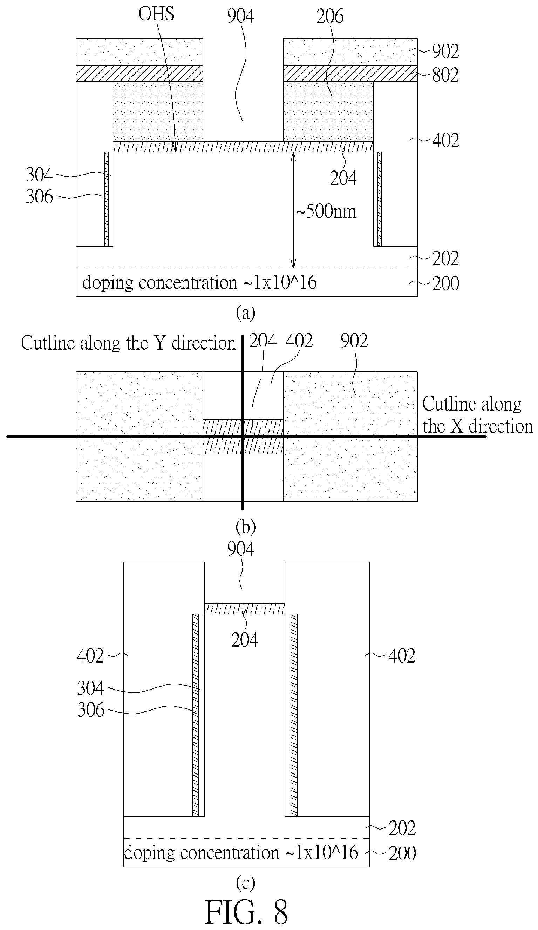

In Step 112, as shown in FIG. 8(a), utilize the photolithographic (PR) mask 902 to define the gate region across over the active region and the STI region 402 so that the thin nitride layer 802 and the pad-nitride layer 206 corresponding to the gate region are removed to create the concave 904. In addition, FIG. 8(b) is a top view corresponding to FIG. 8(a), wherein FIG. 8(a) is a cross-section view along a cutline of an X direction shown in FIG. 8(b) and FIG. 8(c) is a cross-section view along a cutline of a Y direction shown in FIG. 8(b).

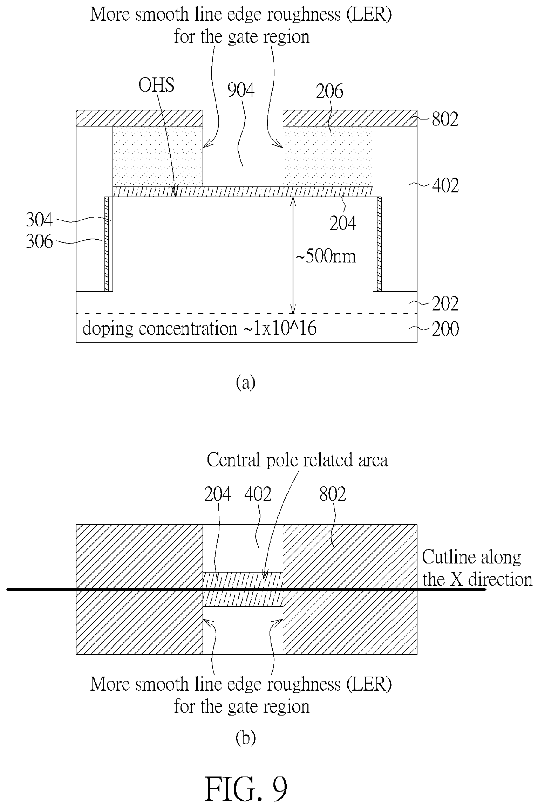

In Step 114, as shown in FIG. 9(a), remove the photolithographic (PR) mask 902. Thus, smooth edges along the thin nitride layer 802 and the pad-nitride layer 206 for the gate region of the VTBFET is achieved , and a central pole related area is also defined within the active region. In addition, FIG. 9(b) is a top view corresponding to FIG. 9(a), wherein FIG. 9(a) is a cross-section view along a cutline of an X direction shown in FIG. 9(b).

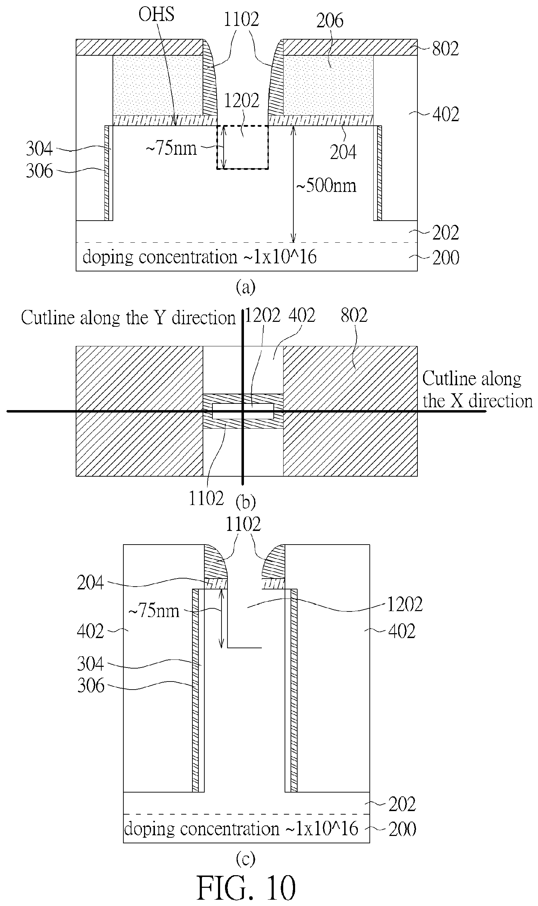

In Step 116, as shown in FIG. 10(a), the SiCOH layer (or a combination of oxide/nitride layer) is deposited within the central pole related area and is etched back to form the SiCOH spacer-2 1102 (wherein for example, a width of the SiCOH spacer-2 1102 could be 1~3 nm). As shown in FIG. 10(b), the SiCOH spacer-2 1102 on four surrounding edges inside the central pole related area, and the SiCOH spacer-2 1102 protects the original silicon regions underneath, which becomes a Surrounding Ring of Silicon (or surrounding Si ring) on the future created central pole, named as SRS-CP.

In Step 118, as shown in FIG. 10(a), then based on the SiCOH spacer-2 1102 and the thin nitride layer 802, use the anisotropic etching technique to etch the pad-oxide layer 204 and the semiconductor material of the substrate 200 in the central pole related area to form the concave (or trench) 1202 with a depth around 50-80nm (e.g. 75nm) in the exposed silicon region. That is, the SiCOH spacer-2 1102 and the thin nitride layer 802 acts as a mask such that the exposed pad-oxide layer 204 in the central pole related area could be removed, so is the exposed silicon at the central pole related area by approximately 75nm deep, to create the concave 1202 at the central pole related area. The SiCOH spacer-2 1102 works like an awning to protect the SRS-CP to be created. In addition, FIG. 10(b) is a top view corresponding to FIG. 10(a), wherein FIG. 10(a) is a cross-section view along a cutline of an X direction shown in FIG. 10(b) and FIG. 10(c) is a cross-section view along a cutline of a Y direction shown in FIG. 10(b).

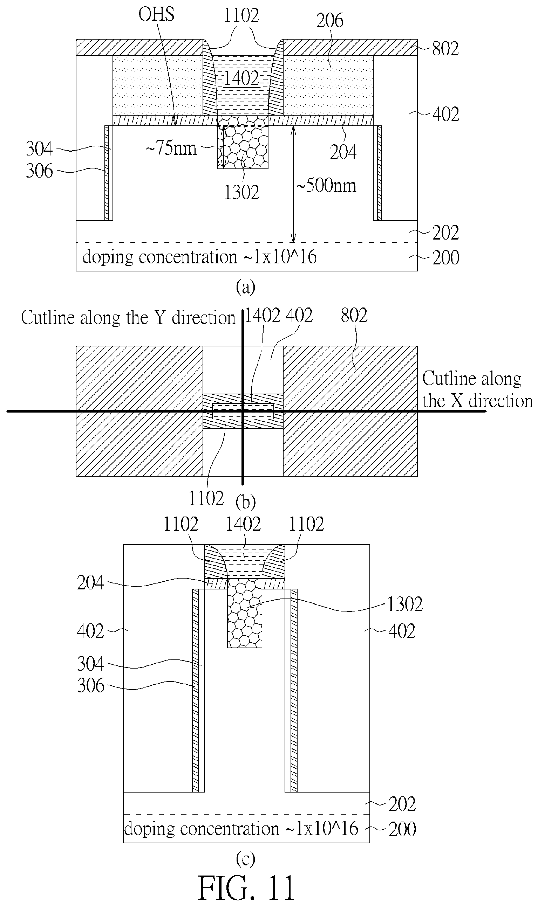

In Step 120, as shown in FIG. 11(a), form the dielectric layer (such as, perform short-time growth of the thermal oxide, or chemical vapor deposition (CVD) deposition) to fill the concave 1202 with the central pole 1302, or called as central oxide pole or column pole (CP).

In Step 122, as shown in FIG. 11(a), then deposit the nitride layer-3 and etch back the nitride layer-3 to form the nitride cap 1402 over the central pole 1302 to protect the central pole 1302. In addition, FIG. 11(b) is a top view corresponding to FIG. 11(a), wherein FIG. 11(a) is a cross-section view along a cutline of an X direction shown in FIG. 11(b) and FIG. 11(c) is a cross-section view along a cutline of a Y direction shown in FIG. 11(b).

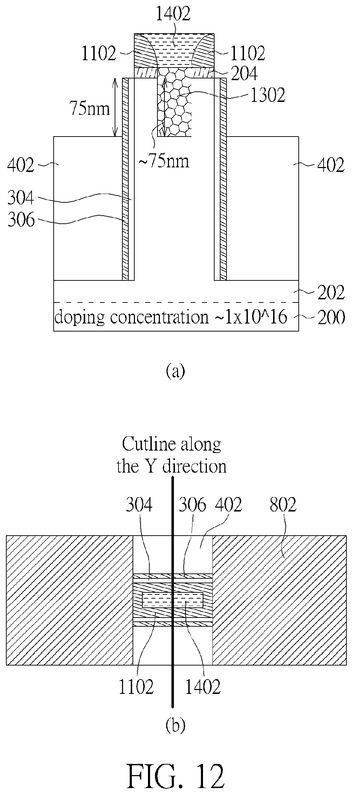

In Step 124, as shown in FIG. 12(a), etch back the exposed STI region 402 by a depth about 50-80nm to create the vertical convex structure in the defined gate region, wherein the STI region 402 in the defined gate region is etched down about 75nm to form the convex height, and in one example the convex height is the same or substantially the same as a height of the central pole 1302 calculated from the original horizontal surface (OHS) of the p-type well 202 to a bottom of the central pole 1302. In addition, FIG. 12(b) is a top view corresponding to FIG. 12(a), wherein FIG. 12(a) is a cross-section view along a cutline of a Y direction shown in FIG. 12(b).

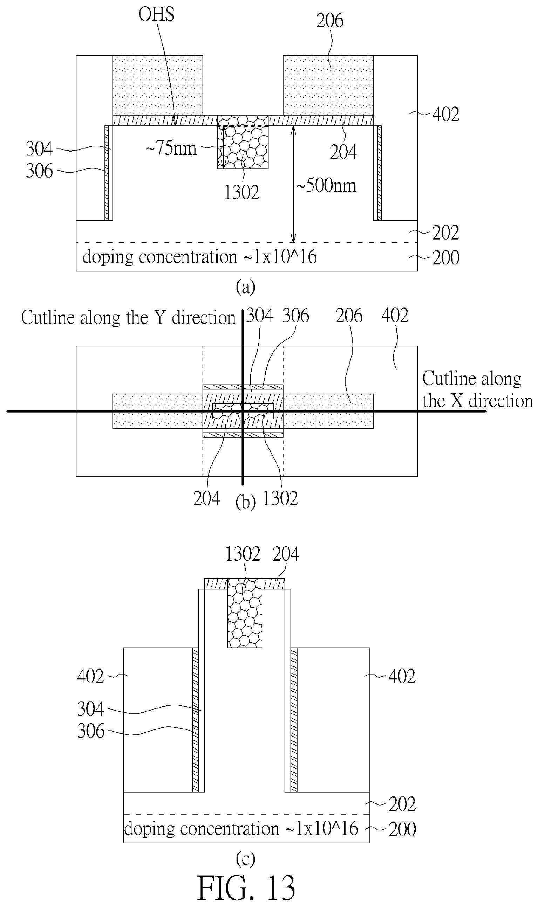

In Step 126, as shown in FIG. 13(a), use etching to remove the nitride cap 1402 and the SiCOH spacer-2 1102 close to the central pole related area, the thin nitride layer 802, and the nitride spacer 306 covering the convex structure in the defined gate region. Thus, the previously defined central pole related area is shown again. In addition, FIG. 13(b) is a top view corresponding to FIG. 13(a), wherein FIG. 13(a) is a cross-section view along a cutline of an X direction shown in FIG. 13(b) and FIG. 13(c) is a cross-section view along a cutline of a Y direction shown in FIG. 13(b).

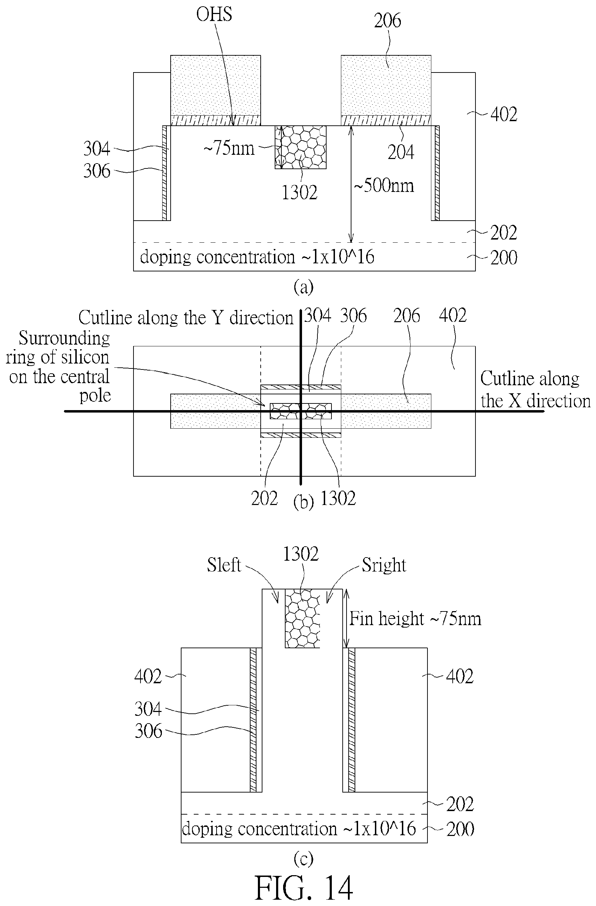

In Step 128, as shown in FIG. 14(a), use etching to remove the pad-oxide layer 204 close to the central pole related area and the oxide spacer 304 covering the convex structure. The STI region 402 outside the gate region could be also etched down by a certain amount (e.g. 40-80nm deep) and the top surface of the STI region 402 is lower than the top surface of the pad-nitride layer 206. Thus, as shown in FIG. 14(c), two outer sides of single crystalline silicon of the convex structure are exposed. More importantly, as shown in FIG. 14(b), there is a Surrounding Ring of Silicon on the central pole (SRS-CP) 1302. In addition, FIG. 14(b) is a top view corresponding to FIG. 14(a), wherein FIG. 14(a) is a cross-section view along a cutline of an X direction shown in FIG. 14(b) and FIG. 14(c) is a cross-section view along a cutline of a Y direction shown in FIG. 14(b).

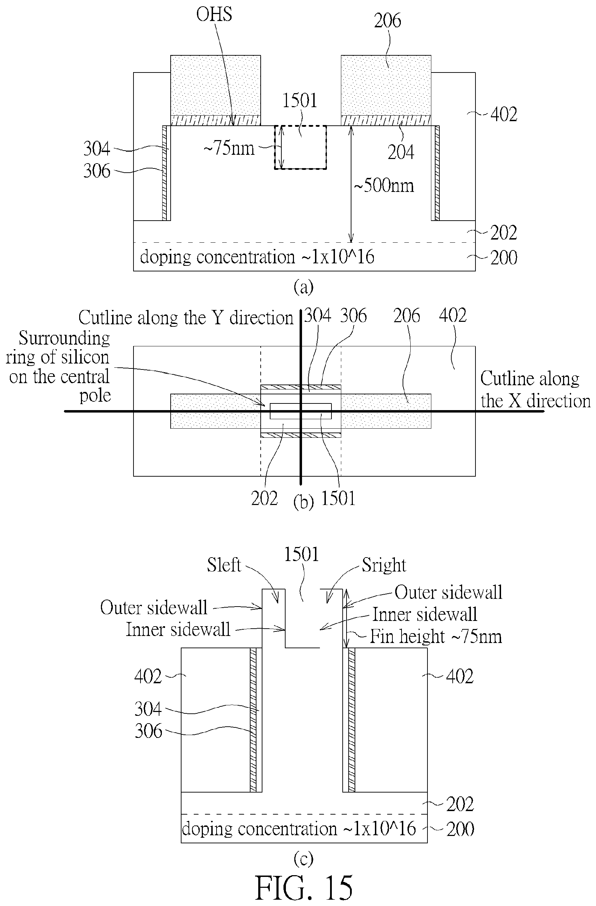

Thereafter, as shown in FIG. 15(a), the central pole 1302 is removed and a trench-2 1501 is revealed. As shown in FIG. 15(c), in the convex structure, there are two vertical thin silicon bodies Sright, Sleft for current conduction during the ON state of the VTBFET. The vertical thin body Sright has one outer sidewall and one inner sidewall next to the trench-2 1501, so does the vertical thin body Sleft. The inner sidewall of the vertical thin body Sright faces the inner sidewall of the vertical thin body Sleft in the trench-2 1501. In addition, FIG. 15(b) is a top view corresponding to FIG. 15(a), wherein FIG. 15(a) is a cross-section view along a cutline of an X direction shown in FIG. 15(b) and FIG. 15(c) is a cross-section view along a cutline of a Y direction shown in FIG. 15(b).

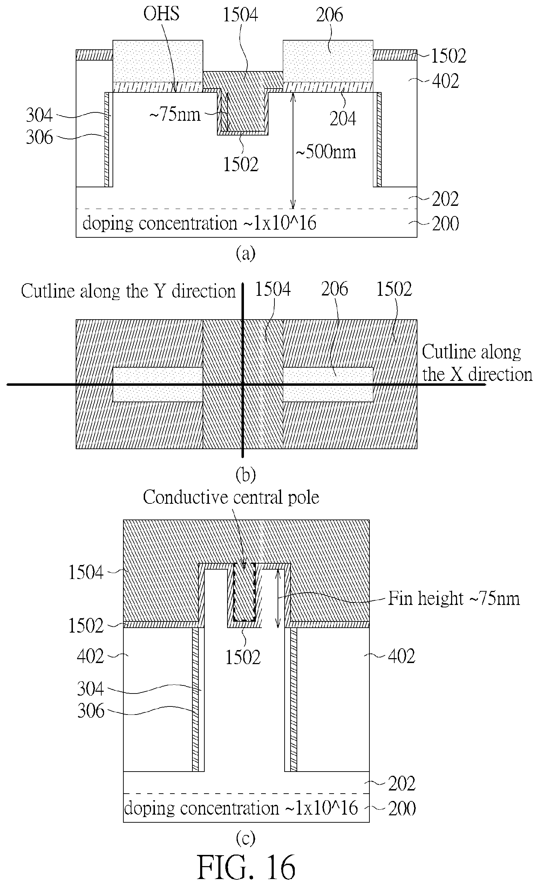

In Step 130, as shown in FIG. 16(a), then form the gate dielectric (such as high K dielectric materials or oxide) 1502 in the gate region.

In Step 132, as shown in FIG. 16(a), subsequently deposit the gate conductive material (such as polysilicon, or metal like Tungsten over TiN layer, or other Metal with suitable work function) 1504 in the gate region, use the CMP technique to remove the excess gate conductive material 1504, and then etch back/polish the gate conductive material 1504. Of course, in the event there is a gate last process, the previously formed gate conductive material 1504 could be removed and replaced by other suitable gate conductive material. The portion of the gate conductive material 1504 in the trench-2 1501 could be called "conductive central pole", and the conductive central pole is surrounded by the gate dielectric 1502 in the trench-2 1501. In addition, FIG. 16(b) is a top view corresponding to FIG. 16(a), wherein FIG. 16(a) is a cross-section view along a cutline of an X direction shown in FIG. 16(b) and FIG. 16(c) is a cross-section view along a cutline of a Y direction shown in FIG. 16(b).

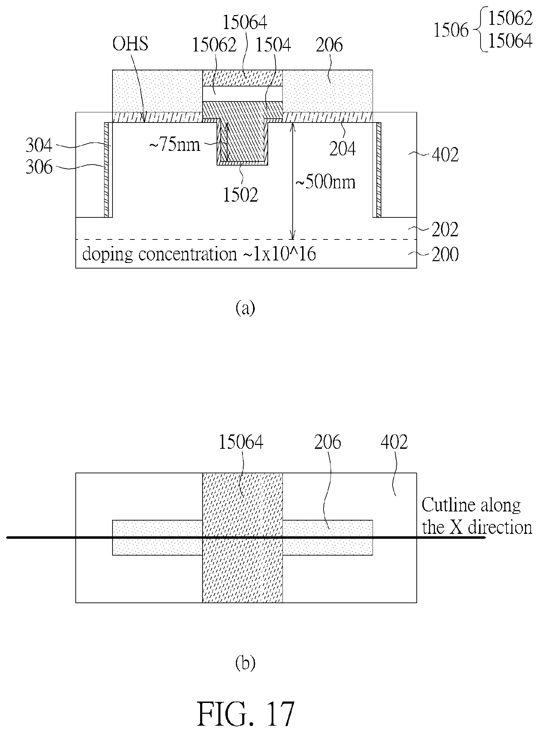

In Step 134, as shown in FIG. 17(a), then deposit the cap layer 1506 which could be composed of a nitride layer 15062 and a Hardmask-oxide layer 15064 into the gate region on a top surface of the gate material 1504, wherein the cap layer 1506 is used for protecting the gate conductive material 1504. Then, the cap layer 506 is polished by the CMP technique to make a top surface of the cap layer 1506 in level up to the top surface of the pad-nitride 206.

In Step 136, as shown in FIG. 17(a), then etch the STI region 402 (including the gate dielectric 1502 over the STI region 402, if any) to make a top surface of the STI 402 in level up to the top surface of the pad-oxide layer 204. In addition, FIG. 17(b) is a top view corresponding to FIG. 17(a), wherein FIG. 17(a) is a cross-section view along a cutline of an X direction shown in FIG. 17(b).

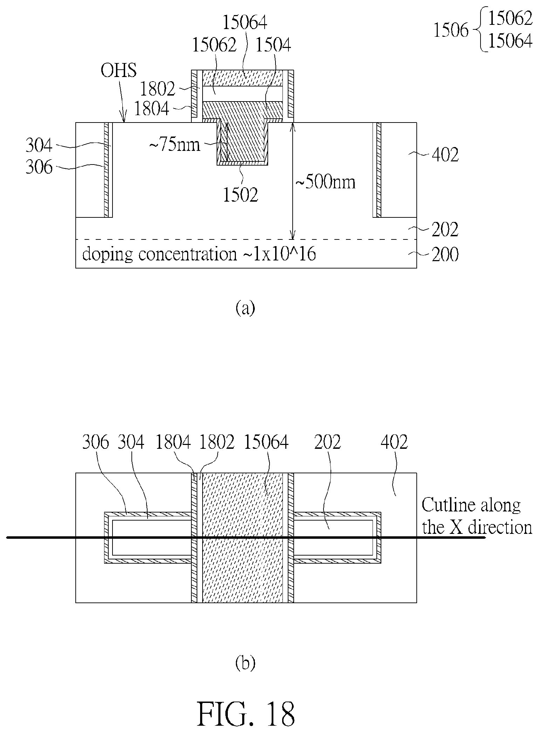

In Step 138, as shown in FIG. 18(a), etch away the pad-nitride layer 206 and the pad-oxide layer 204 to reveal the OHS. Moreover, etch back some portion of the STI region 402 to make the top surface of the STI 402 in level up to the OHS.

In Step 140, as shown in FIG. 18(a), then deposit an oxide-2 layer to form the oxide-2 spacer 1802 and a nitride-2 layer to form the nitride-2 spacer 1804 on the edges of the gate material 1504 and the cap layer 506. In addition, FIG. 18(b) is a top view corresponding to FIG. 18(a), wherein FIG. 18(a) is a cross-section view along a cutline of an X direction shown in FIG. 18(b).

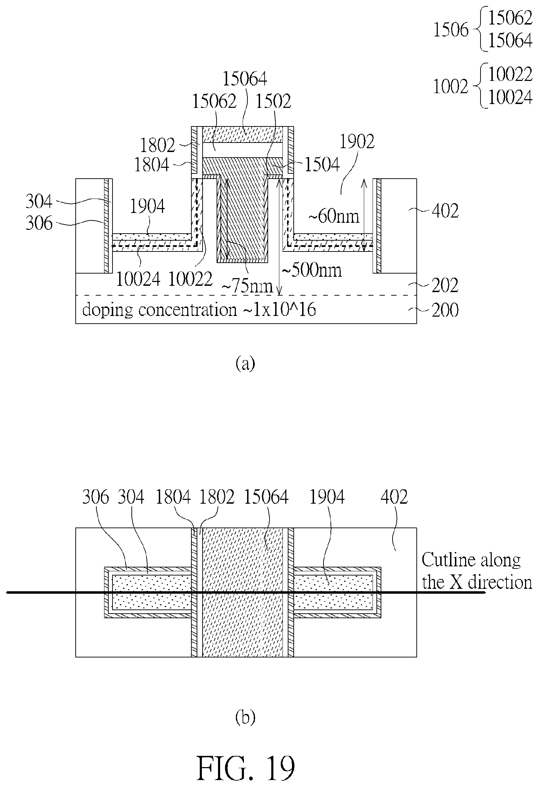

In Step 142, as shown in FIG. 19(a), then etch away some exposed silicon areas in the active region to create shallow trenches 1902 for the source region and the drain region (e.g. about 50nm~60nm deep) of the VTBFET.

In Step 144, as shown in FIG. 19(a), use a thermal oxidation process, called as an oxidation-3 process, to grow the oxide-3 layer 1002 (including both an oxide-3V layers 10022 penetrating vertical sidewalls of the bulk body of the VTBFET (assuming with a sharp crystalline orientation (110)) and an oxide-3B layer 10024 over the bottom of the shallow trenches 1902). Since some sidewalls of the shallow trenches 1902 have vertical composite materials of the oxide-2 spacer 1802 and the nitride-2 spacer 1804, and those sidewalls of the shallow trenches 1902 is further surrounded the STI region 402, the oxidation-3 process should grow little oxide (i.e. the oxide-3 layer 1002) on these walls such that a width of the source/drain of the VTBFET is not really affected by the thermal oxidation process. In addition, a thickness of the oxide-3V layer 10022 and the oxide-3B layer 10024 drawn in FIG. 19(a) and following figures are only shown for illustration purpose, and its geometry is not proportional to the dimension of the STI region 402 shown in those figures. For example, the thickness of the oxide-3V layer 10022 and the oxide-3B layer 10024 is around 10~30 nm, but the vertical height of the STI region 402 could be around 200-250 nm. Based on the oxidation-3 process, the thickness of oxide-3V layer 10022 can be very accurately controlled under both precisely controlled thermal oxidation temperature, timing and growth rate. Since the thermal oxidation over a well-defined silicon surface should result in that 40% of the thickness of the oxide-3V layer 10022 is taken away the thickness of the exposed (110) silicon surface in the vertical wall of the bulk body of the VTBFET and the remaining 60% of the thickness of the oxide-3V layer 10022 is counted as an addition outside the vertical wall of the bulk body of the VTBFET. In one embodiment, the edge of the oxide-3V layer 10022 could be aligned or substantially aligned with the edge of the gate structure .

In Step 146, as shown in FIG. 19(a), use CVD to deposit nitride on a top surface of the oxide-3B layer 10024 and etch back the nitride to form the nitride layer 1904. In addition, FIG. 19(b) is a top view corresponding to FIG. 19(a), wherein FIG. 19(a) is a cross-section view along a cutline of an X direction shown in FIG. 19(b).

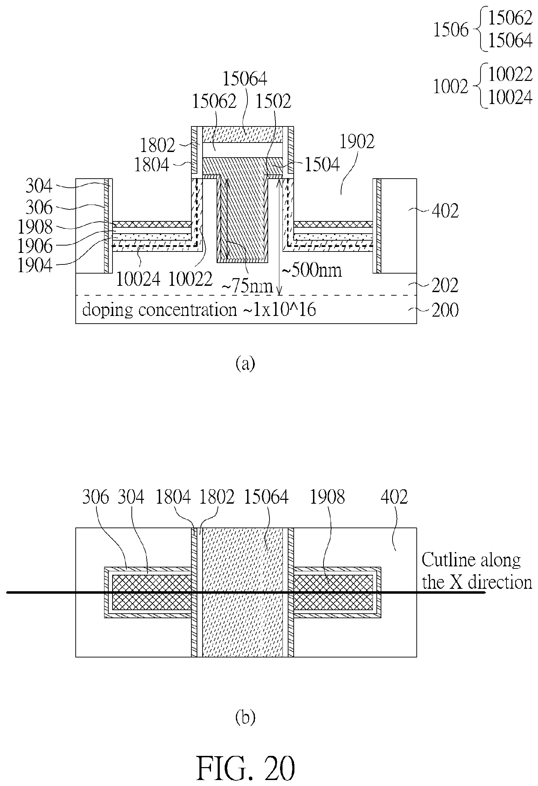

In Step 148, as shown in FIG. 20(a), deposit tungsten and etch back tungsten to form the tungsten layer 1906 on a top surface of the nitride layer 1904.

In Step 150, as shown in FIG. 20(a), then deposit (such as, Atomic Layer Deposition, ALD) TiN and etch back TiN to form the TiN layer 1908 above a top surface of the tungsten layer 1906. In addition, FIG. 20(b) is a top view corresponding to FIG. 20(a), wherein FIG. 20(a) is a cross-section view along a cutline of an X direction shown in FIG. 20(b).

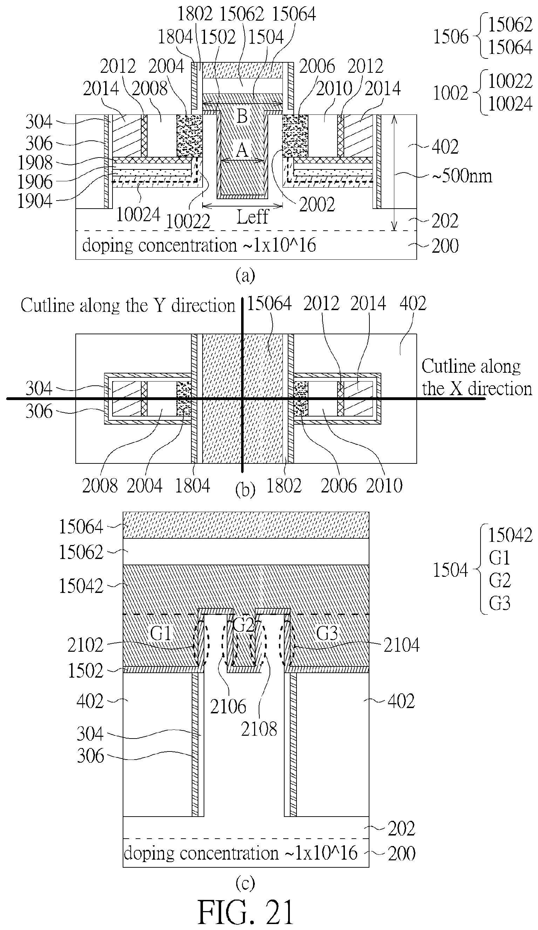

In Step 152, as shown in FIG. 21(a), then use a top surface of the TiN layer 1908 as reference to etch away the portion of the oxide-3V layer 10022 to reveal silicon sidewalls 2002 (with the crystalline orientation (110) of the silicon region).

In another example, the steps to form the tungsten layer 1906 and the TiN layer 1908 in FIG. 20 could be omitted, and etching the portion of the oxide-3V layer 10022 in Fig. 21 could use the top surface of the nitride layer 1904 as reference.

In Step 154, as shown in FIG. 21(a), then use the selective growth technique (such as selective epitaxy growth (SEG) technique) to form the n-type LDDs 2004, 2006 and then the n+ doped source 2008 and n+ doped drain 2010. To be mentioned, no ion-implantations for forming all n-type LDDs 2004, 2006, the n+ doped source 2008, and n+ doped drain 2010 of the proposed VTBFET are needed and no high temperature thermal annealing is necessary to remove those damages due to heavy bombardments of forming the n+ doped source 2008 and n+ doped drain 2010.

As shown in FIG. 21(a), finally, deposit the TiN layer 2012 and the Tungsten layer 2014 (such as, could be carried out by Atomic Layer Deposition) and etch back the TiN layer 2012 and the Tungsten layer 2014. In one example, as shown in FIG. 21(a), the bottom of the conductive central pole is lower than the bottom of the oxide-3B layer 10024. The height of the n+ doped source 2008 and n+ doped drain 2010 is around 40-60nm.

In one example, the convex height (~75nm) is higher than the height of the n+ doped source 2008 and n+ doped drain 2010 (or the height of the TiN layer 2012 and the Tungsten layer 2014) about 10~30 nm (such as 20nm). Thus, the gap between the bottom of the gate structure and the n+ doped source 2008 and n+ doped drain 2010 (or the bottom of the TiN layer 2012 and the Tungsten layer 2014) about 10~30 nm (such as 20nm), that is, the bottom of the gate structure (either the gate dielectric 1502 or the gate material 1504) is lower than the bottom of the n+ doped source 2008 and n+ doped drain 2010 (or the bottom of the TiN layer 2012 and the Tungsten layer 2014).

As shown in FIG. 21(c), FIG. 21(c) shows the VTBFET has its three vertical gate conductive portions G1~G3 which are connected by a top gate conductive portion 15042 of the gate material 1504. As previously described, there are four vertical sidewalls of the convex structure covered by the gate dielectric 1502 and the gate material 1504. In the vertical gate conductive portion G1, the gate conductive material, the oxide (i.e. the gate dielectric 1502) and the semiconductor material (i.e. the p-type well 202) along one outer sidewall form a conductor-oxide-semiconductor structure 2102 which is similar to MOS structure. Also, In the vertical gate conductive portion G3, the gate conductive material, the oxide (i.e. the gate dielectric 1502) and the semiconductor material (i.e. the p-type well 202) along another outer sidewall form a conductor-oxide-semiconductor structure 2104. Similarly, in the vertical gate conductive portion G2 (or the conductive central pole), the gate conductive material, the oxide and the semiconductor material along the inner sidewalls form another two conductor-oxide-semiconductor structures 2106 and 2108. Therefore, there are four conductor-oxide-semiconductor structures (or MOS structures) 2102, 2104, 2106, and 2108. According to the present invention, the uniqueness in the above embodiment is that there are four conductor-oxide-semiconductor structures 2102, 2104, 2106, 2108 sharing one common source and one common drain in the vertical thin body field-effect transistor. However, the present invention could be applied to other multiple MOS structures (6 or 8) in the single convex structure.

In another example, the material of the vertical gate conductive portion G2 could be different from or the same as that of other vertical gate conductive portions G1, G3, or the top gate conductive portion 15042.

Furthermore, as shown in FIG. 21(a), since there is a surrounding ring portion made of semiconductor in the convex structure, the length "B" of the gate conductive layer above the OHS is longer than the length "A" of the conductive central pole. Moreover, the lateral length of the outer sidewall of the convex structure is longer than that of the inner sidewall of the convex structure. In addition, FIG. 21(b) is a top view corresponding to FIG. 21(a), wherein FIG. 21(a) is a cross-section view along a cutline of an X direction shown in FIG. 21(b) and FIG. 21(c) is a cross-section view along a cutline of a Y direction shown in FIG. 21(b).

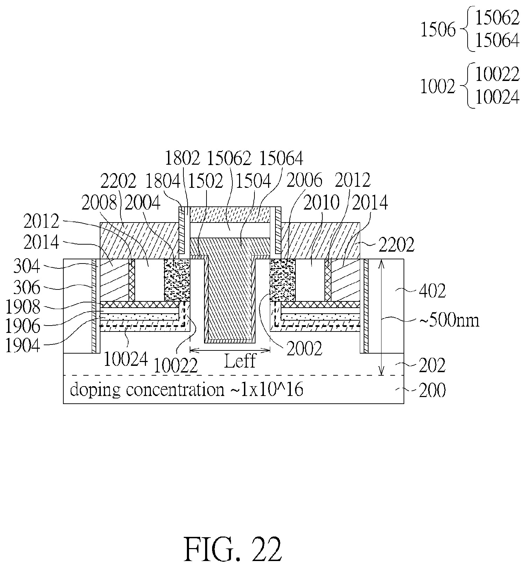

Moreover, as shown in FIG. 22, when the landing pads 2202 are formed over the n+ doped source 2008 and n+ doped drain 2010, at least two sides (one sidewall and top side) of the n+ doped drain 2010 (or the n+ doped source 2008) are contacted by the TiN layer 2012/the Tungsten layer 2014 and the landing pad, and therefore, so the contact resistance is reduced accordingly.

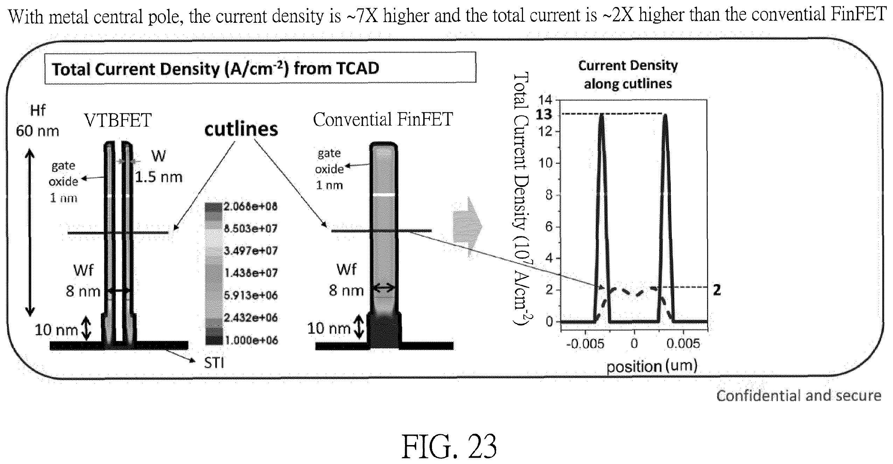

FIG. 23 shows the TCAD simulation results of the Ion regarding the conventional FinFET and the VTBFET of the present invention, wherein the conventional FinFET (middle drawing of FIG. 23) has 8nm fin width, 70nm fin height, 1nm thickness gate oxide, and the VTBFET (left drawing of FIG. 23) has Sright with 1.5nm , Sleft with 1.5nm, and 1nm thickness gate oxide covering the Sleft and Sright. The conductive central pole (not shown in FIG. 23) exists between the Sleft and Sright. With suitable gate metal material to adjust the work function of the conductive central pole and/or the gate conductive material, the current density (marked by blue curve) during the ON-state of the VTBFET is 7 times of that (marked by brown dash curve) of the conventional FinFET, and Ion of the present invention is around 2 times of that of the conventional FinFET transistor. It is noticed that, due to the Sleft and Sright thin bodies, there are multiple current conductive channels in the new vertical thin body field-effect transistor.

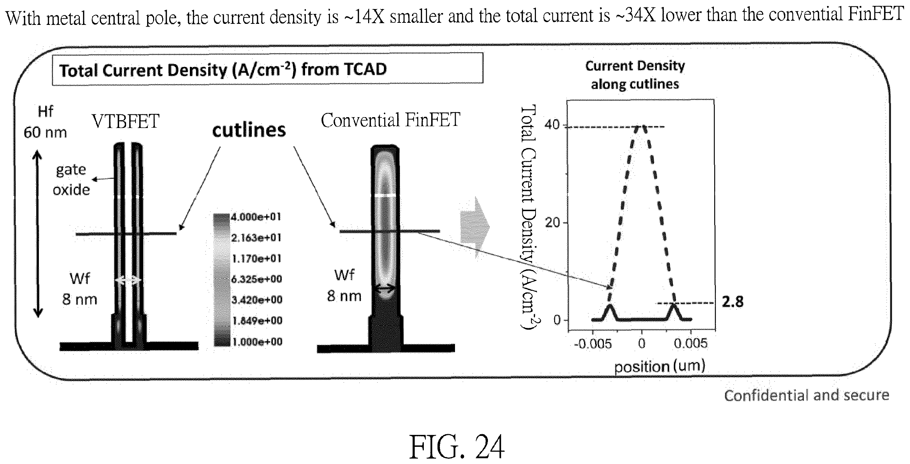

On the other hand, FIG. 24 shows the TCAD simulation results of the loff regarding the conventional FinFET and the VTBFET of the present invention. Based on the same structure, as shown in right drawing of FIG. 24, the current density (marked by brown dash curve) during the Off-state of the conventional FinFET is 17 times of that (marked by blue curve) of VTBFET of the present invention, and loff of the conventional FinFET transistor is 34 times of that of VTBFET of the present invention. Thus, the present invention effectively improves the Ion/Ioff ratio about 68 times, as compared with the convention FinFET.

Moreover, since the width of the Sleft/Sright is around 1.5~3nm (that is, the width of the surrounding Si ring is around 1.5~3nm), during the selective growth the LDD and the highly doped semiconductor region at a predetermined temperature, in another example, the edge of the LDD region 2006 may be laterally shifted to contact the gate dielectric 1502, so is the edge of the LDD region 2008. Thus, in this example, the effective channel length of the VTBFET may be shorter than the effective channel length (Leff) of the VTBFET shown in FIG. 21(a).

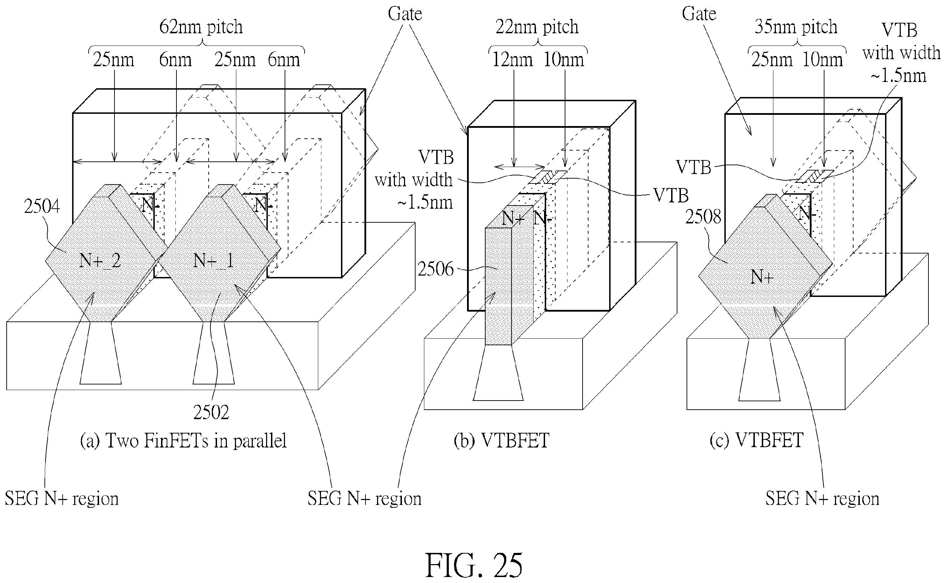

FIG. 25 shows structure differences between the conventional FinFET and the VTBFET of the present invention. As shown in FIG. 25(a) which is corresponding to the conventional FinFET, to increase the Ion current, usually there are two (or more) independent fin structures which are separated from each other by the STI region, wherein the STI region is between the two independent fin structures. A gate dielectric layer and a gate conductive layer will cross over the two independent fin structures and the STI region therebetween. Then each terminal of the fin structure provides one seed region for selective grown epitaxy of LDD region and highly doped region. Thus, two N+ regions 2502, 2504 of the two fin structures are separately grown by the selective epitaxy growth (SEG) technique, and because the two grown N+ regions 2502, 2504 in the conventional FinFET are not limited by the STI region, those two N+ regions 2502, 2504 are gradually expanded like two separate mushrooms, and finally the two N+ regions 2502, 2504 are connected together. Thus, the transistor body of the conventional FinFET in FIG. 25(a) includes two (or more) independent fin structures, the width of each fin structure is 6nm, the width of the STI region between the two independent fin structures could be 25nm, and the width of the STI region between this convention FINFET and another same convention FINFET is 25nm as well. Therefore, the pitch distance between two convention FINFETs of FIG.25(a) is 62nm.

However, as shown in FIG. 25(b) which is corresponding to one embodiment of the present invention, there is just one single convex structure formed based on the semiconductor substrate and one trench is formed in the convex structure such that there are two vertical thin bodies, as described previously. However, there is no STI region between those two vertical thin bodies. Then a gate dielectric layer and a gate conductive layer will cross over the two vertical thin bodies and the trench therebetween, wherein the portion of the gate conductive layer in the trench (that is, the conductive central pole as previously mentioned) is surrounded by the gate dielectric layer, especially along four sidewalls and the bottom of the trench . Under the bottom of the trench is still the semiconductor material of the substrate. Therefore, there is no STI region between two vertical thin bodies.

Even there are two vertical thin bodies, because of the existence of the surrounding Si ring as previously mentioned, one revealed terminal of the surrounding Si ring just provides one seed region, rather than two separate seed regions, for selective grown epitaxy of LDD region and highly doped region. Furthermore, in this embodiment, the N+ region 2506 of the VTBFET is grown by the selective epitaxy growth (SEG) technique in a concave limited by STI region, as described in FIG. 21. Thus, the transistor body of the VTBFET in FIG. 25(b) just includes one single convex structure (or fin structure) which has two vertical thin bodies which extend upward, and the width of the vertical thin body is around 1.5nm and the height of the vertical thin body could be around 50-70nm. In each vertical thin body, there are two MOS structures or two conductive channels ("2C" shown in FIG. 25(b)) along two sidewalls of the vertical thin body. In this embodiment, the LDD region of the source/drain region contacts with the two vertical thin bodies due to the lateral shift which is caused by the thermal processes, as previously described. The width of the STI region between this VTBFET and another same VTBFET could be 12nm. Therefore, the pitch distance between two VTBFETs of FIG.25(b) could be as low as 22nm.

In addition, FIG. 25(c) is corresponding to another embodiment, and the major difference between FIG. 25(b) and FIG. 25(c)is that, N+ region 2508 is not grown in concave limited by STI region, therefore, the N+ region 2508 is gradually expanded like a single mushroom. Again, Even there are two vertical thin bodies in the single convex structure, because of the existence of the surrounding Si ring as previously mentioned, one revealed terminal of the surrounding Si ring just provides one seed region, rather than two separate seed regions, for selective grown epitaxy of LDD region and highly doped region.

In summary, there is a conductive central pole in the convex structure in the VTBFET, and the conductive central pole is encompassed by the gate dielectric. Such conductive central pole within the single convex structure can effectively suppress the leakage current path during the OFF state of the VTBFET. However, the VTBFET still has multiple vertical thin bodies (i.e. Sright and Sleft) for current conduction during the ON state. In addition, for example, the width of the Sright (or Sleft) could be around 1.5~2nm. Since the conductive central pole is encompassed by a Surrounding Ring of Silicon, thus a conductive current during an ON state of the VTBFET is diverged and then converged in the conductive channel region extending from the drain region to the source region.

Moreover, the solid fence wall (such as the oxide spacer 304 and then the nitride spacer 306 shown in FIG. 6) is formed to clamp the active region or the narrow convex structure, especially the sidewalls of the convex structure. The solid fence wall could be a single layer or other composite layers to protect the narrow convex structure from collapse during the forming the source/the drain or the gate structure of the VTBFET. Furthermore, the STI region 402 (shown in FIG. 7) further encompass or clamp the active region or the narrow convex structure, especially the sidewalls of the convex structure, to protect the narrow convex structure from collapse during the forming the source/the drain or the gate of the VTBFET. Thus, even the height of the convex structure (such as 60~300nm) is far larger than the width of the convex structure (such as 3~7nm) of the VTBFET, the convex structure protected by the solid fence wall of the present invention is unlikely vulnerable during the following processes (such as the source/the drain formation, gate formation, etc.).

Another advantage of the present invention is that, since the thickness of the oxide-2 spacer 1802 and the nitride-2 spacer 1804 formed on the edges of the gate region (shown in FIG. 18) is controllable, and the thickness of the oxide-3V layer 10022 and the oxide-3B layer 10024 (shown in FIG. 19) made by the thermal oxidation process is controllable as well, the edge of the source/the drain could be aligned or substantially aligned with the edge of the gate region (as shown in FIG. 21), especially the source/the drain is formed by the SEG technique. Thus, according to the present invention, the relative position or distance between the edge of the source/the drain and the edge of the gate region is controllable, and could be dependent on the thickness of spacer formed on the edges of the gate region and/or the thickness of the oxide layer (such as the oxide-3V layer 10022). Therefore, an effective channel length Leff could be controlled such that the gate-induced drain leakage (GIDL) current issue could be improved.

To sum up, the proposed VTBFET of the present invention has advantages as follows:
(1) The leakage current path during the OFF state is reduced, due to the existence of the conductive central pole which is surrounded by the gate dielectric layer in the convex structure, and such a conductive central pole surrounded by the gate dielectric layer within the convex structure can effectively suppress the leakage current path during the OFF state of the transistor. Moreover, there are multiple vertical thin bodies in the convex structure, and those multiple vertical thin bodies further increase the conductive current during the ON state of the transistor.
(2) By using a process with a minimum feature size of a 5 nm as example, a new vertical thin body field-effect transistor with multiple MOS structures and multiple conductive channels has its structure having the following dimensions: the first two thin bodies built up between their gates have the body of 1.5 nm, the gate dielectric thickness of 1 nm, the inside gate (conductive central pole) thickness of around 3 nm, thus requiring the starting convex thickness about 8 nm. By assuming the STI width between two convex structures is 8 nm, then the pitch (space plus width) of the vertical thin body field-effect transistor is 16 nm (=3.2F), which is much smaller than the pitch of a state-of-the-art FinFET which has a fin width of 6 nm and the space between two fins is 24 nm, thus such a transistor pitch is 30 nm (=6F).
(3) FIGS. 23, 24 show some device simulation results of the vertical thin body field-effect transistor versus the conventional FinFET (or Tri-gate). The Ion of the present vertical thin body field-effect transistor can be >2X and loff can be <34X, their respective absolute values are quite improved. This improvement is achievable with a device width pitch of <4F of the vertical thin body field-effect transistor versus 6F of the state-of-the-art FinFET. So the productivity of the vertical thin body field-effect transistor is really much better and worthwhile for executing the new structure with quite affordable processing complexity.
(4) A solid fence wall is formed to clamp the active region or the narrow convex structure, especially the sidewalls of the convex structure. Thus, even the height of the convex structure (such as 60~300nm) is far larger than the width of the convex structure (such as 3-7nm), the convex structure protected by the sold wall of the present invention is unlikely vulnerable.
(5) The relative position or distance between the edge of the source/drain region and the edge of the gate region is controllable, dependent on the thickness of spacer formed on the edges of the gate and/or the thickness of the oxide layer (such as the oxide-3V layer).
(6) The resistance of the source/drain region could be improved by forming metal-semiconductor junction in the source/drain region.
(7) Most the source/drain areas are isolated by insulation materials including the bottom structure by the oxide-3B and/or Nitride-3, the junction leakage can be significantly reduced.

## Claims

1. A transistor structure **characterized in that** comprising:
a body with a single convex structure, wherein the convex structure is made of a first semiconductor material, and a trench is formed in the single convex structure;
a gate structure with a gate conductive layer and a gate dielectric layer, wherein the gate conductive layer is across over the single convex structure, and a first portion of the gate conductive layer is filled in the trench;
wherein the single convex structure comprises two vertical thin bodies, and the gate dielectric layer is disposed between the gate conductive layer and the two vertical thin bodies.

2. The transistor structure in claim 1, further **characterized in that** a bottom surface and sidewalls of the trench are covered by the gate dielectric layer.

3. The transistor structure in claim 1, further **characterized in that** the convex structure comprises a first outer sidewall and a second outer sidewall covered by the gate conductive layer, the convex structure further comprises a first inner sidewall and a second inner sidewall in the trench; wherein a length of the first inner sidewall or the second inner sidewall is shorter than that of the first outer sidewall or the second outer sidewall.

4. The transistor structure in claim 1, further **characterized in that** a bottom of the gate conductive layer outside the single convex structure is lower than that of the portion of the gate conductive layer is filled in the trench.

5. The transistor structure in claim 1, further **characterized in that** further comprising:
a source region contacting with a first end of the single convex structure;
a drain region contacting with a second end of the single convex structure;
a first concave accommodating the source region; and
a second concave accommodating the drain region;
wherein sidewalls of the first concave and sidewalls of the second concave are surrounded by a STI region.

6. The transistor structure in claim 5, further **characterized in that** an edge of the source region contacts with the two vertical thin bodies, and an edge of the drain region contacts with the two vertical thin bodies.

7. The transistor structure in claim 6, further **characterized in that** the source region comprises:
an LDD region contacting with the two vertical thin bodies;
a heavily doped region laterally extending from the LDD region; and
a metal region being in the first concave and contacting with a sidewall of the heavily doped region.

8. The transistor structure in claim 5, f further **characterized in that** further comprising:
an oxide layer positioned in the first concave, wherein the oxide layer comprises a vertical portion and a lateral portion covering a bottom of the first concave; wherein a top surface of the vertical portion is higher than that of the lateral portion; and
a nitride layer above the oxide layer.

9. The transistor structure in claim 1, further **characterized in that** a width of one vertical thin body is not greater than 3nm.

10. The transistor structure in claim 1, further **characterized in that** the convex structure has a first end, a second end, and multiple conductive channels; the first portion of the gate conductive layer filled in the convex structure is under the original surface, and a second portion of the gate conductive layer is above the original surface; wherein a length of the second portion of the gate conductive layer is longer than that of the first portion of the gate conductive layer.

11. The transistor structure in claim 10, further **characterized in that** the trench formed in the convex structure is between the first end and the second end of the single convex structure, the single convex structure comprises two thin bodies extending upward, each thin body comprises two conductive channels along sidewalls of the thin body, and the trench filled with the first portion of the gate conductive layer is between the two thin bodies.

12. The transistor structure in claim 11, further **characterized in that** the gate dielectric layer is across over the convex structure, the first portion of the gate conductive layer is surrounded by the gate dielectric layer in the trench, and right under the bottom of the trench is the semiconductor material of the body, and the gate dielectric layer along the bottom of the trench directly contacts with the semiconductor material of the body.

13. The transistor structure in claim 1, further **characterized in that**
the single convex structure has a trench formed therein and comprises at least 4 upward extending conductor-oxide-semiconductor interfaces on the two vertical thin bodies;
wherein the at least 4 upward extended conductor-oxide-semiconductor interfaces are horizontally shifted with each other.

14. The transistor structure in claim 13, further **characterized in that** the single convex structure comprises two upward extending thin bodies, and each upward extending thin body comprises two upward extending conductor-oxide-semiconductor interfaces.

15. The transistor structure in claim 14, further **characterized in that** no STI region is between the two upward extending bodies, and the convex structure is made of a first semiconductor material, a bottom of the trench directly contacts with the first semiconductor material.

16. The transistor structure in claim 13, further **characterized in that** the trench formed in the single convex structure separates the two upward extending thin bodies.

17. The transistor structure in claim 13, further **characterized in that** further comprising:
a single source region selectively grown from a first end of the single convex structure; and
a single drain region selectively grown from a second end of the single convex structure.

## Patentansprüche

1. Transistorstruktur, **dadurch gekennzeichnet, dass** diese umfasst:
einen Körper mit einer einzigen konvexen Struktur, worin die konvexe Struktur aus einem ersten Halbleitermaterial besteht und in der einzigen konvexen Struktur ein Graben ausgebildet ist;
eine Gatter-Struktur mit einer Gatter-Leitschicht und einer Gatter-Dielektrikumsschicht, worin sich die Gatter-Leitschicht über die einzige konvexe Struktur erstreckt und ein erster Abschnitt der Gatter-Leitschicht den Graben ausfüllt;
worin die einzelne konvexe Struktur zwei vertikale dünne Körper umfasst und die Gatter-Dielektrikumsschicht zwischen der Gatter-Leitschicht und den beiden vertikalen dünnen Körpern angeordnet ist.

2. Transistorstruktur nach Anspruch 1, ferner **dadurch gekennzeichnet, dass** eine Bodenfläche und Seitenwände des Grabens von der Gatter-Dielektrikumsschicht bedeckt sind.

3. Transistorstruktur nach Anspruch 1, ferner **dadurch gekennzeichnet, dass** die konvexe Struktur eine erste äußere Seitenwand und eine zweite äußere Seitenwand umfasst, die von der Gatter-Leitschicht bedeckt sind, worin die konvexe Struktur ferner eine erste innere Seitenwand und eine zweite innere Seitenwand in dem Graben umfasst; worin eine Länge der ersten inneren Seitenwand oder der zweiten inneren Seitenwand kürzer ist als die der ersten äußeren Seitenwand oder der zweiten äußeren Seitenwand.

4. Transistorstruktur nach Anspruch 1, ferner **dadurch gekennzeichnet, dass** ein Boden der Gatter-Leitschicht außerhalb der einzelnen konvexen Struktur tiefer liegt als derjenige des Abschnitts der Gatter-Leitschicht, der den Graben ausfüllt.

5. Transistorstruktur nach Anspruch 1, ferner **dadurch gekennzeichnet, dass** diese ferner umfasst:
einen Quellenbereich, der mit einem ersten Ende der einzelnen konvexen Struktur in Kontakt steht;
einen Abflussbereich, der mit einem zweiten Ende der einzelnen konvexen Struktur in Kontakt steht;
eine erste Vertiefung, die den Quellenbereich aufnimmt; und
eine zweite Vertiefung, die den Abflussbereich aufnimmt;
worin Seitenwände der ersten Vertiefung und Seitenwände der zweiten Vertiefung von einem STI-Bereich umgeben sind.

6. Transistorstruktur nach Anspruch 5, ferner **dadurch gekennzeichnet, dass** eine Kante des Quellenbereichs mit den beiden vertikalen dünnen Körpern in Kontakt steht und eine Kante des Abflussbereichs mit den beiden vertikalen dünnen Körpern in Kontakt steht.

7. Transistorstruktur nach Anspruch 6, ferner **dadurch gekennzeichnet, dass** der Quellenbereich umfasst:
einen LDD-Bereich, der mit den beiden vertikalen dünnen Körpern in Kontakt steht;
einen stark dotierten Bereich, der sich seitlich vom LDD-Bereich erstreckt; und
einen Metallbereich, der sich in der ersten Vertiefung befindet und mit einer Seitenwand des stark dotierten Bereichs in Kontakt steht.

8. Transistorstruktur nach Anspruch 5, ferner **dadurch gekennzeichnet, dass** diese ferner umfasst:
eine in der ersten Vertiefung angeordnete Oxidschicht, worin die Oxidschicht einen vertikalen Abschnitt und einen lateralen Abschnitt umfasst, der einen Boden der ersten Vertiefung bedeckt; worin eine Oberseite des vertikalen Abschnitts höher liegt als die des lateralen Abschnitts; und
eine Nitridschicht über der Oxidschicht.

9. Transistorstruktur nach Anspruch 1, ferner **dadurch gekennzeichnet, dass** die Breite eines vertikalen dünnen Körpers nicht größer als 3 nm ist.

10. Transistorstruktur nach Anspruch 1, ferner **dadurch gekennzeichnet, dass** die konvexe Struktur ein erstes Ende, ein zweites Ende und mehrere leitende Kanäle aufweist; worin sich ein erster Abschnitt der in die konvexe Struktur eingefüllten Gatter-Leitschicht unterhalb der ursprünglichen Oberfläche befindet und ein zweiter Abschnitt der Gatter-Leitschicht oberhalb der ursprünglichen Oberfläche liegt; worin die Länge des zweiten Abschnitts der Gatter-Leitschicht größer ist als die des ersten Abschnitts der Gatter-Leitschicht.

11. Transistorstruktur nach Anspruch 10, ferner **dadurch gekennzeichnet, dass** sich der in der konvexen Struktur ausgebildete Graben zwischen dem ersten Ende und dem zweiten Ende der einzelnen konvexen Struktur befindet, die einzelne konvexe Struktur zwei sich nach oben erstreckende dünne Körper umfasst, jeder dünne Körper zwei leitfähige Kanäle entlang der Seitenwände des dünnen Körpers umfasst und sich der mit dem ersten Abschnitt der Gatter-Leitschicht gefüllte Graben zwischen den beiden dünnen Körpern befindet.

12. Transistorstruktur nach Anspruch 11, ferner **dadurch gekennzeichnet, dass** sich die Gatter-Dielektrikumsschicht über der konvexen Struktur erstreckt, der erste Abschnitt der Gatter-Leitschicht in dem Graben von der Gatter-Dielektrikumsschicht umgeben ist und sich direkt unter dem Boden des Grabens das Halbleitermaterial des Körpers befindet, worin die Gatter-Dielektrikumsschicht entlang des Bodens des Grabens in direktem Kontakt mit dem Halbleitermaterial des Körpers steht.

13. Transistorstruktur nach Anspruch 1, ferner **dadurch gekennzeichnet, dass**
die einzelne konvexe Struktur einen darin ausgebildeten Graben aufweist und mindestens vier sich nach oben erstreckende Leiter-Oxid-Halbleiter-Grenzflächen auf den beiden vertikalen dünnen Körpern umfasst;
worin die mindestens vier sich nach oben erstreckenden Leiter-Oxid-Halbleiter-Grenzflächen horizontal zueinander versetzt sind.

14. Transistorstruktur nach Anspruch 13, ferner **dadurch gekennzeichnet, dass** die einzelne konvexe Struktur zwei sich nach oben erstreckende dünne Körper umfasst und jeder sich nach oben erstreckende dünne Körper zwei sich nach oben erstreckende Leiter-Oxid-Halbleiter-Grenzflächen umfasst.

15. Transistorstruktur nach Anspruch 14, ferner **dadurch gekennzeichnet, dass** sich zwischen den beiden sich nach oben erstreckenden Körpern kein STI-Bereich befindet und die konvexe Struktur aus einem ersten Halbleitermaterial besteht, worin ein Boden des Grabens in direktem Kontakt mit dem ersten Halbleitermaterial steht.

16. Transistorstruktur nach Anspruch 13, ferner **dadurch gekennzeichnet, dass** der in der einzelnen konvexen Struktur ausgebildete Graben die beiden sich nach oben erstreckenden dünnen Körper trennt.

17. Transistorstruktur nach Anspruch 13, ferner **dadurch gekennzeichnet, dass** diese ferner umfasst:
einen einzelnen Quellenbereich, der selektiv von einem ersten Ende der einzelnen konvexen Struktur her gewachsen ist; und
einen einzelnen Abflussbereich, der selektiv von einem zweiten Ende der einzelnen konvexen Struktur her gewachsen ist.

## Revendications

1. Structure de transistor **caractérisée en ce qu'**elle comprend:
un corps présentant une structure convexe unique, dans lequel la structure convexe est constituée d'un premier matériau semi-conducteur, et une tranchée est formée dans la structure convexe unique;
une structure de grille comprenant une couche conductrice de grille et une couche diélectrique de grille, dans laquelle la couche conductrice de grille recouvre la structure convexe unique, et une première partie de la couche conductrice de grille remplit la tranchée;
dans laquelle la structure convexe unique comprend deux corps minces verticaux, et la couche diélectrique de grille est disposée entre la couche conductrice de grille et les deux corps minces verticaux.

2. Structure de transistor selon la revendication 1, **caractérisée en outre en ce qu'**une surface inférieure et des parois latérales de la tranchée sont recouvertes par la couche diélectrique de grille.

3. Structure de transistor selon la revendication 1, **caractérisée en outre en ce que** la structure convexe comprend une première paroi latérale extérieure et une deuxième paroi latérale extérieure recouvertes par la couche conductrice de grille, la structure convexe comprenant en outre une première paroi latérale intérieure et une deuxième paroi latérale intérieure dans la tranchée; dans laquelle la longueur de la première paroi latérale intérieure ou de la deuxième paroi latérale intérieure est inférieure à celle de la première paroi latérale extérieure ou de la deuxième paroi latérale extérieure.

4. Structure de transistor selon la revendication 1, **caractérisée en outre en ce que** le fond de la couche conductrice de grille situé à l'extérieur de la structure convexe unique est plus bas que celui de la partie de la couche conductrice de grille qui remplit la tranchée.

5. Structure de transistor selon la revendication 1, **caractérisée en outre en ce qu'**elle comprend en outre:
une région de source en contact avec une première extrémité de la structure convexe unique;
une région de drain en contact avec une deuxième extrémité de la structure convexe unique;
une première concavité logeant la région de source; et
une deuxième concavité logeant la région de drain;
dans laquelle les parois latérales de la première concavité et les parois latérales de la deuxième concavité sont entourées par une région STI.

6. Structure de transistor selon la revendication 5, **caractérisée en outre en ce qu'**un bord de la région de source est en contact avec les deux corps minces verticaux, et un bord de la région de drain est en contact avec les deux corps minces verticaux.

7. Structure de transistor selon la revendication 6, **caractérisée en outre en ce que** la région de source comprend:
une région LDD en contact avec les deux corps minces verticaux;
une région fortement dopée s'étendant latéralement à partir de la région LDD; et
une région métallique située dans la première concavité et en contact avec une paroi latérale de la région fortement dopée.

8. Structure de transistor selon la revendication 5, **caractérisée en outre en ce qu'**elle comprend en outre:
une couche d'oxyde disposée dans la première concavité, dans laquelle la couche d'oxyde comprend une partie verticale et une partie latérale recouvrant le fond de la première concavité; dans laquelle la surface supérieure de la partie verticale est plus haute que celle de la partie latérale; et
une couche de nitrure au-dessus de la couche d'oxyde.

9. Structure de transistor selon la revendication 1, **caractérisée en outre en ce que** la largeur d'un corps mince vertical n'est pas supérieure à 3 nm.

10. Structure de transistor selon la revendication 1, **caractérisée en outre en ce que** la structure convexe comporte une première extrémité, une deuxième extrémité et plusieurs canaux conducteurs; la première partie de la couche conductrice de grille remplissant la structure convexe se trouve sous la surface d'origine, et une deuxième partie de la couche conductrice de grille se trouve au-dessus de la surface d'origine; dans laquelle la longueur de la deuxième partie de la couche conductrice de grille est supérieure à celle de la première partie de la couche conductrice de grille.

11. Structure de transistor selon la revendication 10, **caractérisée en outre en ce que** la tranchée formée dans la structure convexe se situe entre la première extrémité et la deuxième extrémité de la structure convexe unique, la structure convexe unique comprend deux corps minces s'étendant vers le haut, chaque corps mince comprend deux canaux conducteurs le long de ses parois latérales, et la tranchée remplie de la première partie de la couche conductrice de grille se situe entre les deux corps minces.

12. Structure de transistor selon la revendication 11, **caractérisée en outre en ce que** la couche diélectrique de grille recouvre la structure convexe, la première partie de la couche conductrice de grille est entourée par la couche diélectrique de grille dans la tranchée, et juste sous le fond de la tranchée se trouve le matériau semi-conducteur du corps, et la couche diélectrique de grille le long du fond de la tranchée est en contact direct avec le matériau semi-conducteur du corps.

13. Structure de transistor selon la revendication 1, **caractérisée en outre en ce que**
la structure convexe unique comporte une tranchée formée en son sein et comprend au moins 4 interfaces conducteur-oxyde-semi-conducteur s'étendant vers le haut sur les deux corps minces verticaux;
dans laquelle les au moins 4 interfaces conducteur-oxyde-semi-conducteur s'étendant vers le haut sont décalées horizontalement les unes par rapport aux autres.

14. Structure de transistor selon la revendication 13, **caractérisée en outre en ce que** la structure convexe unique comprend deux corps minces s'étendant vers le haut, et chaque corps mince s'étendant vers le haut comprend deux interfaces conducteur-oxyde-semi-conducteur s'étendant vers le haut.

15. Structure de transistor selon la revendication 14, **caractérisée en outre en ce qu'**aucune région STI ne se trouve entre les deux corps s'étendant vers le haut, et **en ce que** la structure convexe est constituée d'un premier matériau semi-conducteur, le fond de la tranchée étant en contact direct avec le premier matériau semi-conducteur.

16. Structure de transistor selon la revendication 13, **caractérisée en outre en ce que** la tranchée formée dans la structure convexe unique sépare les deux corps minces s'étendant vers le haut.

17. Structure de transistor selon la revendication 13, **caractérisée en outre en ce qu'**elle comprend en outre:
une région de source unique formée de manière sélective à partir d'une première extrémité de la structure convexe unique; et
une région de drain unique formée de manière sélective à partir d'une deuxième extrémité de la structure convexe unique.
